**Europäisches Patentamt**

(19) **European Patent Office**

**Office européen des brevets**

(11) Publication number : **0 484 412 B1**

(12) **EUROPEAN PATENT SPECIFICATION**

(45) Date of publication of patent specification :
24.11.93 Bulletin 93/47

(51) Int. Cl.⁵ : **H03M 13/00**

(21) Application number : **90911689.9**

(22) Date of filing : **18.07.90**

(86) International application number :
**PCT/EP90/01201**

(87) International publication number :
**WO 91/01598 07.02.91 Gazette 91/04**

(54) **PROCESS AND DEVICE FOR THE DECODING OF A SHORTENED CYCLIC BINARY CODE USING ERROR CORRECTION.**

(30) Priority : **25.07.89 IT 2128889**

(43) Date of publication of application :
**13.05.92 Bulletin 92/20**

(45) Publication of the grant of the patent :
**24.11.93 Bulletin 93/47**

(84) Designated Contracting States :
**BE DE DK ES FR GB NL SE**

(56) References cited :
**US-A- 3 801 955**
**US-A- 4 677 623**
**IBM TECHNICAL DISCLOSURE BULLETIN vol. 30,no.5 Oct. 1987,NEW YORK US pages 41-44.**

(56) References cited :
**IEEE Transactions on Information Theory, vol.15, no.1, January 1969, New York US, pages 109-113; R.T.Chien: "Burst-correcting codes with high-speed decoding"**
**IBM Technical Disclosure Bulletin, vol.31, no.7, December 1988, New York US, pages 332-335; "Fire-code decoding"**
**W.W.Peterson: "Error-correcting codes" 1961, The M.I.T.Press and John Wiley & Sons Inc. New York US; pages 183-199**

(73) Proprietor : **ITALTEL SOCIETA ITALIANA TELECOMUNICAZIONI s.p.a.**
**P.le Zavattari, 12**
**I-20149 Milano (IT)**

(72) Inventor : **TURCO, Ermanno**
**Via Tommaso Gulli, 60**
**I-20147 Milan (IT)**

(74) Representative : **Giustini, Delio et al**
**c/o Italtel Società Italiana Telecomunicazioni s.p.a. P.O. Box 10**
**I-20019 Settimo Milanese (MI) (IT)**

EP 0 484 412 B1

## Description

This invention concerns the decoding of a binary code able to correct errors bursts, and, more precisely, a process for the decoding of a cyclic shortened binary Fire code. Moreover this invention relates to a decoding device that tests the presence of such errors and corrects and decodes the received code word.

The rate of digital transmission is getting more and more faster. Errors arising in the transmission channel, due to disturbances such as noise, fading, interferences, and so forth, make the transmission not reliable. Therefore, several techniques are used for the automatic correction of such errors on reception.

This is usually obtained protecting the information to be sent by means of error correction codes. Considering such information as being divided in words of k bits each, the block code (n,k) follows a relationship law coupling each word of information to a n bit long code with n>k. The n-k difference is called redundancy.

Cyclic codes are a class of such kind of codes, where all the words in the code can be obtained starting from a word in the code by means of a process of cyclic shifting.

It is helpful to use polynomials to represent both the information and the code words. So, the information word, a k-tuple $(i_o, i_1, ... i_{k-1})$, will be represented by the polynomial $i_o + i_1x + ... + i_{k-1}x^{k-1} = i(x)$, and the code word, a n-tuple $(c_o, c_1, ... c_{n-1})$, will be represented by $c_o + c_1x + ... + c_{n-1}x^{n-1} = c(x)$. The law of coding itself can be represented by a g(x) polynomial of degree (n-k), the so-called generator, such that the code polynomial c(x) is obtained multiplying the g(x) polynomial by the polynomial i(x). An important class of such codes, able to contrast errors bursts that are typical in memory channels (like radio channels affected by fading) is the class of the so-called Fire codes with GF(2), the above notation representing double value (0 and 1) Galois fields. The generator polynomial of such kind of codes can be expressed in a general form by:

$$g(x) = (x^{2t-1} - 1)p(x) \quad (1)$$

where p(x) is an m degree irreducible polynomial.

Let ro be the period of p(x), i.e. the smallest integer such that p(x) divides $(x^{ro} + 1)$ and t a positive integer, smaller or equal to m, such that (2t-1) is not divisible by ro.

The code length (the number of bits in each code word) is the least common multiple of (2t-1) and ro, and the number of redundant bits is (m+2t-1).

Further on, we shall indicate the Fire codes with the notation F(n,k), where n indicates the length of the coded word, k is the length of the information word and (n-k) is the redundancy.

A code with generator polynomial g(x) given by (1), for which the above conditions expressed for m, ro and (2t-1) are verified, is able to correct any single errors burst (i.e. the sequence of bits included between the first and the last erroneus bit in the code word) shorter or equal to t, and also to detect the presence of errors burst longer than t.

Fire codes can be decoded using decoders belonging to the family of "Error Trapping' decoders. In such devices, the time required for correcting the errors is equal to n cycles, n being the length of the code word.

In technical literature, there are some known decoders studied "ad hoc" for the Fire codes, able to correct errors in a shorter time. One of such devices is discussed in IBM Technical Disclosure Bulletin, Vol. 30 No. 5 October 1987. This article described a traditional Fire-Code Decoding technique in which the received code word is considered as a single polynomial from which a single syndrome is computed by shifting in one direction and an error correction is accomplished by shifting in the reverse direction. Another of such devices has been proposed by R.T. Chien in his paper 'Burst-correcting codes with high-speed decoding", IEEE Trans. on Information Theory, Vol. IT-15, Nr. 1, January 1969, pages 109 to 113.

This document discloses a process for the decoding of a shortened cyclic binary code, able to correct single errors bursts b(x) of given length t or shorter, specially a F(n-b,k-b) shortened Fire code, with generator polynomial $g(x)=(x^{2t-1} +1).p(x)$, p(x) being a prime polynomial over GF(2) with period ro, satisfying the ro>(n-b), condition, where:

the received code word r(x) is buffered in a shift register as a received vector and the syndrome polynomials s1(x) and s2(x) are calculated in (n-b) cycles;

the polynomial s1(x) is cyclic shifted a $\Gamma 1$ number of times in a first direction until all zeros are obtained in the (t-1) higher order positions, so to trap the burst b(x) of length t in the lowest order positions.

Once the code word has been inputted, Chien's decoder can correct errors in a number of cycles (this being the delay with which the correct code can be obtained) given at most by:

$$(2t - 2) + (ro - 1) \quad (2)$$

As for a Fire code, n is the least common multiple of (2t-1) and ro, and as (2t-1) is not divisible by ro, n can at most be equal to ro.(2t-1).

A normal "Error Trapping" decoder would at most take ro.(2t-1) cycles to correct errors. Such value is much larger than the one given by expression (2), and this justifies the given definition for Chien's device as a high speed one.

The basic idea in Chien's decoder is that of using as syndrome a couple of polynomials, s1(x) and s2(x), where s1(x) is the remainder polynomial obtained by dividing the received polynomial r(x) by the factor $(x^{2t-1} + 1)$ in the generator polynomial, and s2(x) is the remainder polynomial obtained by dividing the received. polynomial r(x) by the factor p(x) in the generator polynomial. Above we have used r(x) to represent the received code word that, eventually, contains errors.

Chien's decoder basically consists of two loop back shift registers. Both are fed by the bit sequence received in each generic code word. The first register, called "Error Pattern Register", consists of $(2t-1)$ stages and is used to compute the polynomial $s1(x)$. The second Register, called "Error Location Register' consists of m stages, and is used to calculate the polynomial $s2(x)$.

If both the polynomials $s1(x)$ and $s2(x)$ are null polynomials, no correction is applied, and the device only performs the decoding of the received code word which is error free.

If just one of the two polynomials $s1(x)$ and $s2(x)$ is not a null polynomial, then the device does not decode but detects the presence of errors (the error burst being greater than t).

Finally, if both polynomials $s1(x)$ and $s2(x)$ are not null polynomials, then the error correction process is started, at the end of which the decoding is performed (for errors bursts of length $<=t$).

The correction algorithm is accomplished in four phases:

- Phase 1.
  $s1(x)$ is shifted $\Gamma1$ times in the Error Pattern Register to obtain all zeros in the most significant $(t-1)$ positions. The remaining t positions will be occupied by the components of the polynomial $b(x)$ of degree $(t-1)$. The polynomial $b(x)$ represents, unless an integer number of shifts, the burst to be corrected.
- Phase 2.
  $s2(x)$ is shifted $\Gamma2$ times into the Error Location Register until the polynomial $b(x)$ is obtained in the less significant t positions.
- Phase 3.
  There is only one integer q that, when divided by ro and by $(2t-1)$ gives respectively $\Gamma1$ and $\Gamma2$. The value of q can be calculated using the formula:

$$q = \Gamma1.A2.ro + \Gamma2.A1.(2t - 1) \quad \mod(n) \quad (3)$$

  A1 and A2 being integers that satisfy the condition:

$$A1.(2t - 1) + A2.ro = 1 \quad (4)$$

- Phase 4.
  The polynomial $x^{(n-q)}.b(x)$ is the errors burst to be corrected.

The correction is realized by adding modulo 2 the polynomial $x^{(n-q)}.b(x)$ to the received polynomial $r(x)$.

As said, the length of a Fire code can be given at most by the expression:

$$n = (2^m - 1).(2t - 1) \quad (5)$$

which is verified if ro and $(2t-1)$ are prime to each other.

The formula (5) clearly shows that by an increase of t, m being $\geq t$, the length of the code increases at least of a factor equal to $2^m$. For instance, a Fire code with m=t that corrects 10 bits bursts (t=10) is 19437 bits long.

It is well known that to obtain smaller words, the code can be shortened by substracting b bits from both the information word and its related code word. As a result, a code (n-b,k-b) is obtained. The structural properties of such code will be the same of the initial code.

In the following, we shall indicate with F(N=n-b,K=k-b) a shortened Fire code, obtained by substracting b bits to the information word, and the same amount of bits to the word in the code F(n,k).

As an example, let consider the shortened code F(224,182) with t=12 specified by ETSI/GSM (Groupe Special Mobile), defined by the following generator polynomial:

$$g(x) = (x^{23} + 1).(x^{17} + x^3 + 1) \quad (6)$$

For this code: ro=131071, and n=3014633.

It is exactly in such cases that a shortened code becomes interesting. Even more, in order not to handle words of big length, it is useful to use large values for the b factor. The result of such shortening operation can lead to a N=n-b value smaller than ro, like in the example shown in (6), where N is <<ro.

Let assume the following working hypotesis:
- p(x) primitive on GF(2);
- ro and $(2t-1)$ prime to each other;
- N = n-b<ro, and preferably <ro/2.

If the Chien device is used for decoding and correcting errors, the above mentioned working conditions shall not influence the calculation of $s1(x)$ and $s2(x)$, so the correction algorithm for the errors burst starts when the polynomials $s1(x)$ and $s2(x)$ are not null. Moreover as far as the computation of $\Gamma1$ is concerned, there are no comments to do.

But the calculation of $\Gamma2$ belongs to a different case, where we can observe that:

a) As the word in the shortened code is of length N, the constraint n-q<N applies to the generic component of the polynomial representing the received code word and to the burst $x^{n-q}b(x)$ to be corrected.

b) For n-q=ro-1, it results that $\Gamma2=1$, for n-q=ro-2 it is $\Gamma2=2,...$ for n-q=ro-k it is $\Gamma2=k$.

c) Being $N\leq ro$, let be D=ro-N, the constraint on (n-q) in item a) becomes n-q$\leq$ro-D-1.

d) The constraint on n-q in item c), because of the remarks performed in item b), causes a constraint for $\Gamma2$.
This is $\Gamma2\geq D+1$.

e) The shift Register "Error Locator" is a sequential machine, reaching the state at which is $\Gamma2=D+1$ only after the state transitions with $\Gamma2=1$, $\Gamma2=2,... \Gamma2=D+1$. So, the burst $x^{N-1}b(x)$, being (n-q=N-1), is corrected after D+1 cycles, and the burst $x^{N-\tau}b(x)$, being $(n-q=N-\tau)$, is corrected after $D+\tau$/cycles.

Therefore, even if there is a considerable shortening of the code length, Chien's decoder still takes at least $(ro-N+1)$ stages to correct the errors, making it useless to handle a shortened code. Coming back to the above mentioned example concerning ETSI/GSM, even if the code has a length $n=224$, the error correction process would consist of at least $(ro-N+1)=130848$ cycles.

Furthermore, the error correction process proposed by Chien requires the computing of an expression like (3), which contains six multiplication and one sum, and must, therefore, be implemented by a dedicated real time fast logic, or by means of a quite extended memory table to supply precalculated values of q for each $\Gamma1$ and $\Gamma2$ couple.

Therefore, one of the pourposes of this invention is to avoid the limitations shown above in the already known decoding technique, and specially, to decrease in a considerable way the correction delay in the decoding of shortened Fire codes.

Another purpose of this invention is, to create a faster decoding device working with shortened Fire codes than the ones using the previous technique.

One more aim of the invention is to simplify computation in the error correction process.

All this results are reached using the invention, which consists of a process for decoding a shortened cyclic binary code, which is able to correct single errors bursts $b(x)$ of given length t or shorter, and specially of a shortened $F(n-b,k-b)$ Fire code, with generator polynomial $g(x)=(x^{2t-1}+1).p(x)$, where $p(x)$ is a prime polynomial over GF(2), and having period ro, satisfying the condition $ro>(n-b)$, in which:

the received $r(x)$ code word is stored and the $s1(x)$ and $s2(x)$ syndrome polynomials are calculated in $(n-b)$ cycles;

the $s1(x)$ polynomial is cyclically shifted $\Gamma1$ number of times in a first direction until all zeros are obtained in the $(t-1)$ positions of the higher order so to trap the burst $b(x)$ of length t in the lower order positions;

this procedure is characterized by:
- shifting of the remainder polynomial $s2(x)$, in an opposite direction to the above mentioned first one, until the pattern of the t bits of the lowest order becomes the same as that of the already mentioned burst $b(x)$ of length t, and to calculate a $\Gamma2$ number equal to $(ro-h)$, where h is the amount of shift operations performed;
- calculate $(n-q)$ by the relation:
  $q = \Gamma1.A2.ro + \Gamma2.A1.(2t-1) \quad mod(n)$
  where A1 and A2 are two positive integers such that:
  $$A1.(2t-1) + A2.ro = 1;$$
- perform the correction adding modulo 2 the polynomial $(x^{n-q}).b(x)$ to the received vector.

The invention also consists of a process for the decoding of a shortened cyclic binary code, able to correct single errors bursts $b(x)$ of stated length t or less, in particular of a shortened Fire code $F(n-b,n-k)$ having a generator polynomial $g(x)=(x^{2t-1}+1).p(x)$, where $p(x)$ is a prime polynomial over GF(2) and having period ro, in which, by means of cyclic shift operations, the $\Gamma2$ number is calculated equal to $(ro-h)$, with h given by the number of shifts occurred to trap the errors bursts $b(x)$ in the t less significant positions of the syndrome polynomial $s2(x)$. This way of proceeding being characterized by the fact of calculating $(n-q)$ by the relation:
$$n - q = \Gamma2 + 1 - ro$$
and to perform the correction adding modulo 2 the polynomial $(x^{n-q}).b(x)$ to the received vector.

Moreover, the invention also consists of a decoding device for a shortened cyclic binary code, particularly a $F(n-b,k-b)$ shortened code, having a generator polynomial in the form
$$g(x) = (x^{2t-1} + 1).p(x)$$
where $p(x)$ is a prime polynomial over GF(2) with period ro, satisfying the condition $ro>(n-b)$, said device being able to correct single errors burst of a given length t and comprising:

input means for a code word $(r(X))$;

a first unidirectional shift register, with $(2t-1)$ stages, serially connected to said input means;

a second unidirectional shift register, with m stages, serially connected to said input means;

a test for zero circuit parallely connected to the $(t-1)$ highest order stages of said first register;

first modulo $(2t-1)$ counting means, able to compute the number of shifting operations performed by said first register; characterized by further comprising:

a third unidirectional shift register with m stages, parallely connected with said second register and capable of shifting data in a direction opposed to that of the above first and second registers;

a comparing device, parallely connected between the t lowest order stages of said first unidirectional shift register and said third shift register, the output of said comparing device being connected to second modulo ro counting means able to compute the number of shifting operations performed by said second register;

a computing circuit connected to the outputs of said first and second counting means for computing an $(n-q)$ number able to allow, in the case, the correction of the errors burst in said code word $(r(X))$.

The invention finally consists of a decoding device for shortened cyclic binary code, particularly a $F(n-b,k-b)$ shortened code having a generator polynomial in the form
$$g(x) = (x^{2t-1} + 1).p(x)$$
where $p(x)$ being a prime polynomial over GF(2) with period ro, satisfying the condition $ro>(n-b)$, said device being able to correct single errors bursts of a given length t and comprising:

input means for a code word (r(X));

a first unidirectional shift register with (2t-1) stages, serially connected to said input means;

a second shift register, with m stages, serially connected to said input means;

a test for zero circuit parallely connected to the (t-1) highest order stages of said first register;

first modulo (2t-1) counting means, able to compute the number of shifting operations performed by said first register;

characterized in that

said second shift register is a bidirectional shift register, and in that said device further comprises:

a comparing device parallely connected between the t lowest order stages of said first unidirectional shift register and said second bidirectional shift register, the output of said comparing device being connected to second modulo ro counting means able to compute the number of shifting operations performed by said second register;

a computing circuit connected to the outputs of said first and second counting means for computing an (n-q) number able to allow, in the case, the correction of the error burst in said code word (r(X)).

Further evolutions of the invention are stated in the included claims.

The invention will now be described with more details with references to two realization schemes, shown in the joint drawings, in which:

Fig. 1 shows a decoder that includes the invention;

Fig. 2 shows a possible variation of the decoder according to the invention;

Fig. 3 schematically shows an example of a loop back shift register.

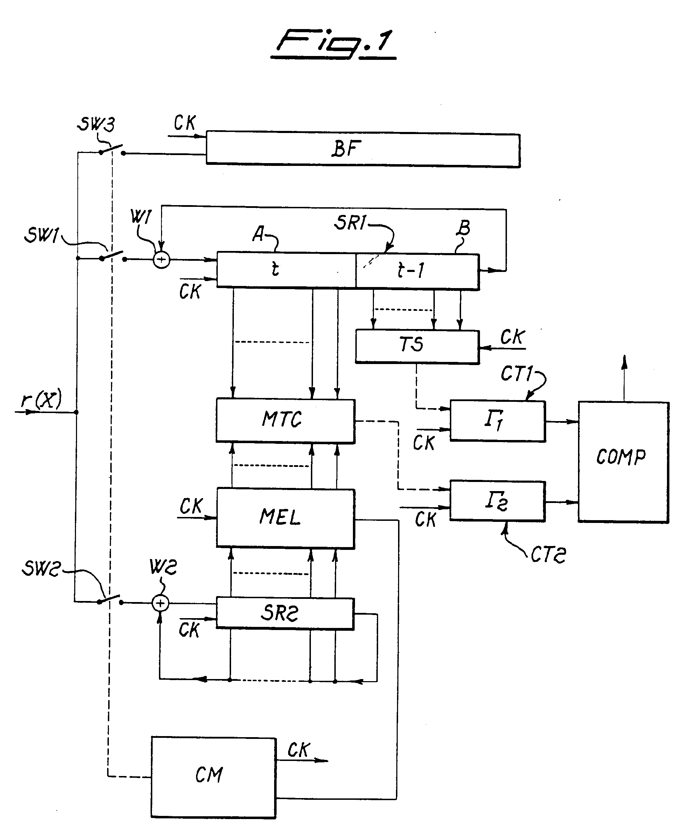

With reference to Fig. 1, the decoder, according to the invention, includes two loop back shift registers SR1 and SR2, receiving as input the received code word r(x) and shifting data from left to right. More precisely, the SR1 register is the "Error Pattern Register", and computes the syndrome polynomial s1(x) that is the remainder of the division of the r(x) polynomial by the factor $(x^{2t-1}+1)$, while the SR2 register, called "Error Locator Register", computes the syndrome polynomial s2(x), which is the remainder of the division of the polynomial r(x) by the factor p(x).

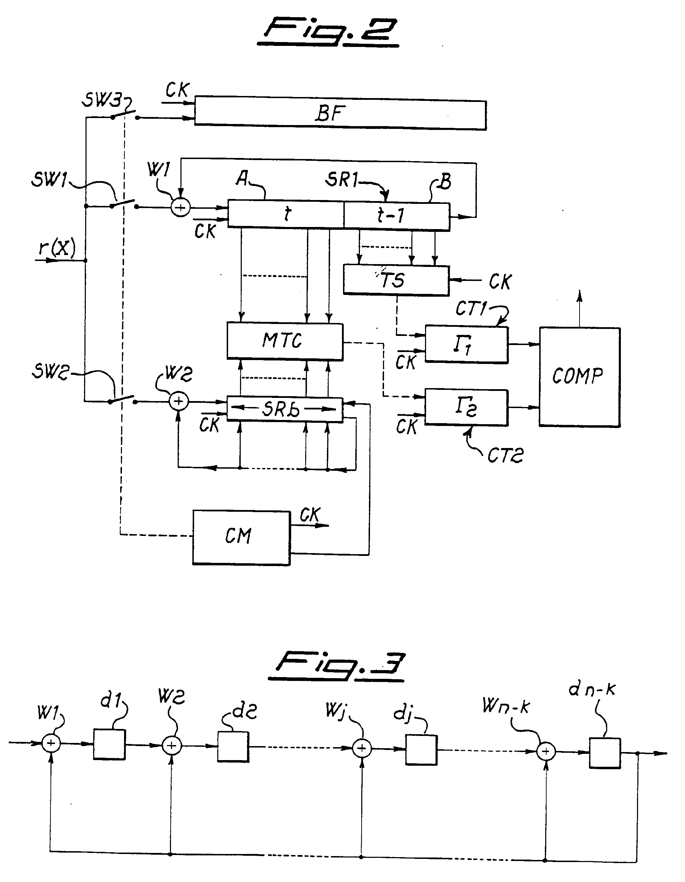

It's well known that the division of a polynomial z(x) of degree n and with coefficients in GF(2) by the polynomial g(x) of degree (n-k) and with coefficients in GF(2) is accomplished in the GF(2) field by shift registers, like, for instance, the one shown in Fig. 3, consisting of (n-k) stages (memory cells) $d_j$ (j = 1,...,n-k), and, at most, of (n-k) exclusive-OR gates $W_j$ supplying the stage $d_j$ with the content of the highest order cell $d_{n-k}$, modulo 2 added to the content of the previous cell $d_{j-1}$.

The generic exclusive-OR gate number j exists physically if the coefficient j of the polynomial g(x) is not zero. At each cycle, the content of each stage is shifted one position to the right. After n-cycles, the entire polynomial z(x) is processed, and the remainder of the division is available in the memory cells corresponding to the positions of the lowest order in the register.

Now, coming back to Fig. 1, in which, not to make the drawing too complicated, a simplified notation is used for a generic realization, after n-b cycles needed to store the code word in the buffer register BF and to compute the two syndrome polynomials s1(x) and s2(x) in the SR1 and SR2 shift registers respectively, the SW1, SW2 and SW3 gates are opened, insulating the registers from the further flow of data. This is performed by the device CM for the supervision and control of the decoder. Moreover, CM also supplies the clock signal CK to the different components.

The register SR1 consists of (2t-1) stages, subdivided in an part A of length t (the less order stages) and in a part B of length (t-1) (the higher order stages). The SR2 register consists of m stages. The register BF consists of n-b stages.

By means of conventional devices that, for semplifity, are not shown in Fig. 1, it's determined if both s1(x) and s2(x) are null and, in such case, the received word r(x) is without errors and is forwarded from the buffer BF to the following decoding and reception circuits, which are not shown, because they are of a known type, and however, they are not relevant for what this invention is concerned.

If only one of the polynomials is not null, this means that a errors burst longer than t, which the device is not able to correct, has been detected. In this case the word r(x) is not decoded.

If both s1(x) and s2(x) are different from null polynomial then the invention's correction process begins.

The polynomial s1(x) is shifted rightwand Γ1 times in the register SR1 until the errors burst is trapped in the part A of the register SR1, which consists of t stages. This condition is verified when the (t-1) stages in the part B of the register SR1 contain all zeros. For this pourpose, the part B of the register SR1 is connected in parallel with a TS circuit, which tests the contents of the part B. The test circuit TS is furthermore connected to a modulo (2t-1) counting device CT1, which initially is set equal to zero, and that is increased of one unit each time a shift in SR1 is performed. If the value in the counting device CT1 overcomes (2t-2), then the presence of errors is detected and the word is not decoded.

The content of the m stages in the register SR2 is transferred in parallel in the m stages of a third shift register MEL (capable of performing a leftwards shift) whose contents are compared to the ones in the t less significant stages of SR1 in a comparing circuit MTC, connected in parallel to the t stages of the part A of the register SR1. If the t stages of the lowest order of such MEL register are recognized as already containing the burst b(x) trapped in the part A of the register SR1, then $\Gamma 2=0$ is set, and the computing of (n-q) is started as it will be shown further on. The MTC is connected in parallel to the MEL register, which may be of a substantially similar construction to the register SR2, but with an opposite shifting direction, i.e. from right to left. In all other cases, $\Gamma 2$ is set equal to (ro-1) in a modulo ro counting device CT2. A shift from left to right is performed in the MEL register until such burst b(x) is obtained in the t lowest order stages. At each new shift, $\Gamma 2$ is decreased of one unit in the counter CT2, so the final value of $\Gamma 2$ will be equal to (ro-k), being k the number of steps necessary to have the burst in the desired position.

If the CT2 counter reaches a value lower than (ro-N+1), then the counting of $\Gamma 2$ is suspended and the presence of errors is signalled, and the word is not decoded because this means that the errors burst is longer than t.

If there results $\Gamma 2 \geqq (ro-N+1)$ the correction is performed calculating a q integer following the relation:
$$q = \Gamma 1.A1.ro + \Gamma 2.A2.(2t - 1) \quad mod(n)$$
where A1 and A2 are positive integers such that
$$A1.(2t - 1) + A2.ro = 1$$
and adding modulo 2 the polinomyal $x^{(n-q)}.b(x)$ to the received vector, which is present in the register BF.

According to another characteristic of the invention, the exponent (n-q) can be easily calculated starting only by $\Gamma 2$ value, and more precisely, following the relation:
$$n - q = \Gamma 2 + 1 - ro$$
that can be implemented in a very simple and cheap way.

In Fig. 1, only the COMP block, connected to the output of the CT1 and CT2 counting means and that performs the calculation of (n-q), is schematically shown, because the rest of the operation is done in a known way. The decoding is also performed in a conventional way, depending of the kind of coding used (systematic or not systematic) and, therefore, is not shown.

The invention is based on the fact that, given a loop back shift register capable to perform the division by the polynomial p(x) of degree m and period ro, the shifting of p positions to the right of the m components of the stored remainder polynomial is equivalent to the leftwards shifting of (ro-p) positions of the same m components when the shifting direction of all the connections of the register are inverted. Specially, a shift to the right for p positions in the register SR2 of the components of the polynomial s2(x) is equivalent to a leftwards shift of (ro-p) positions of the components of the polynomial s2(x) in the register MEL, which is substantially similar to the register SR2, except that all shifting senses have been inverted.

The leftword shifting of the components of the polynomial s2(x) makes so that the state corresponding to $\Gamma 2=D+1$ is reached after N steps, instead of (ro-N+1) = D+1, as in Chien's device, and having assumed N<ro/2, this means a lower number of cycles. As we pointed out, is $\Gamma 2 \geqq D+1$, and N is the maximum number of cycles required to obtain the burst b(x) in the t lower order stages in the register MEL.

Specially, the device according to the invention allows the correction to be performed in (n-b-1)+(2t-1) cycles maximum, ie., for the already mentioned F(224,182), in 224 cycles maximum, instead of the 130848 cycles expected according to the already known technique.

Fig. 2 shows a further application of the decoder according to the invention, where the SRb register is able to shift in both senses and, therefore,. no extra register to perform the leftword shifting is needed. The circuit's working manner is alike to what we wrote with reference to Fig. 1, and is not further described. Even more, in the circuit of fig. 2 the same references have been used to describe the same or equivalent parts that the ones in Fig. 1.

According to the invention, it is therefore possible to obtain a reduction of the amount of cycles needed to correct errors bursts, a reduction becoming remarkable when, as it practically happens, (n-b) <<ro.

The invention allows the advantageous use of shortened Fire codes in digital transmission systems, on memory channels, such as, for example, a digital mobile radio system.

## Claims

1. Process for the decoding of a shortened cyclic binary code, able to correct single errors bursts b(x) of given length t or shorter, specially a F(n-b,k-b) shortened Fire code, with generator polynomial $g(x)=(x^{2t-1}+1).p(x)$, p(x) being a prime polynomial over GF(2) with period ro, satisfying the ro>(n-b) condition, where:

the received code word r(x) is buffered in a shift register as a received vector and the syndrome polynomials s1(x) and s2(x) are calculated in (n-b) cycles;

the polynomial s1(x) is cyclic shifted a $\Gamma 1$ number of times in a first direction until all zeros are obtained in the (t-1) higher order positions, so to trap the burst b(x) of length t in the lowest order positions;

such process is characterized by the fact of:

- shifting of the remainder polynomial s2(x), in an opposite direction to the given first one, until the pattern of the t bits of the lower order is the same as the one in the said burst b(x) of length t, and determining a

number $\Gamma 2$ equal to (ro-h), where h is the number of shifting operations performed;
- calculating (n-q) by the relation:

$$q = \Gamma 1.A2.ro + \Gamma 2.A1.(2t - 1) \quad mod(n)$$

where A1 and A2 are two positive integers such that:

$$A1.(2t - 1) + A2.ro = 1;$$

- performing the correction adding modulo 2 the polynomial $(x^{n-q}).b(x)$ to the received vector.

2. Process according to claim 1, characterized by the fact that $(n-b)<ro/2$.

3. Process according to claim 1 or 2 , characterized by the fact that ro and (2t-1) are prime to each other.

4. Process according to claim 3, characterized by the fact that if $\Gamma 2$ is minor than ro - (n-b) +1, the process is stopped, because the errors burst is greater than t.

5. Process according to claim 4, characterized by the fact that if the pattern consisting of bits in the lowest order of s2(x) is the same as the one in the trapped burst of length t with no need to shift the polynomial s2(x), then $\Gamma 2$ is set equal to zero and (n-q) = 0.

6. Process for the decoding of a shortened cyclic binary code, able to correct single errors bursts b(x) of given length t or shorter, specially for an F(n-b,k-b) shortened Fire code having a generator polynomial $g(x)=(x^{2t-1} +1).p(x)$, p(x) being a prime polynomial over GF(2) and with period ro, in which, by means of cyclic shifting operations, the number $\Gamma 2$ equal to (ro-h) is calculated, with h given by the amount of shifting operations required to obtain the errors burst b(x) in the t less significant positions of the syndrome s2(x) and such process being characterized. by the fact of calculating (n-q) by the relation:

$$n - q = \Gamma 2 + 1 - ro$$

and to perform the correction by adding modulo 2 the polynomial $(x^{n-q}).b(x)$ to the received vector.

7. Process according to claim 6, characterized by the fact that ro satisfies the relation:

$$ro>(n - b).$$

8. A decoding device for a shortened cyclic binary code, particularly a F(n-b,k-b) shortened code, having a generator polynomial in the form

$$g(x) = (x^{2t-1} + 1).p(x)$$

where p(x) is a prime polynomial over GF(2) with period ro, satisfying the condition ro>(n-b), said device being able to correct single errors burst of a given length t and comprising:
input means for a code word (r(X));
a first unidirectional shift register (SR1), with (2t-1) stages, serially connected to said input means;
a second unidirectional shift register (SR2), with m stages, serially connected to said input means;
a test for zero circuit (TS) parallely connected to the (t-1) highest order stages of said first register (SR1);
first modulo (2t-1) counting means (CT1), able to compute the number of shifting operations performed by said first register (SR1); characterized by further comprising:
a third unidirectional shift register (MEL) with m stages, parallely connected with said second register (SR2) and capable of shifting data in a direction opposed to that of the above first and second registers (SR1, SR2);
a comparing device (MTC), parallely connected between the t lowest order stages of said first unidirectional shift register (SR1) and said third shift register (MEL), the output of said comparing device (MTC) being connected to second modulo ro counting means (CT2) able to compute the number of shifting operations performed by said second register (SR2);
a computing circuit (COMP) connected to the outputs of said first (CT1) and second (CT2) counting means for computing a number n-q able to allow, in the case, the correction of the errors burst in said code word (r(X)).

9. A decoding device for shortened cyclic binary code, particularly a F(n-b,k-b) shortened code having a generator polynomial in the form

$$g(x) = (x^{2t-1} + 1).p(x)$$

where p(x) being a prime polynomial over GF(2) with period ro, satisfying the condition ro>(n-b), said device being able to correct single errors bursts of a given length t and comprising:
input means for a code word (r(X));
a first unidirectional shift register (SR1) with (2t-1) stages, serially connected to said input means;
a second shift register (SRb), with m stages, serially connected to said input means;
a test for zero circuit (TS) parallely connected to the (t-1) highest order stages of said first register (SR1);
first modulo (2t-1) counting means (CT1), able to compute the number of shifting operations performed by said first register (SR1); characterized in that
said second shift register (SRb) is a bidirectional shift register, and in that said device further comprises:

a comparing device (MTC) parallely connected between the t lowest order stages of said first unidirectional shift register (SR1) and said second bidirectional shift register (SRb), the output of said comparing (MTC) device being connected to second modulo ro counting means (CT2) able to compute the number of shifting operations performed by said second register (SRb);

a computing circuit (COMP) connected to the outputs of said first (CT1) and second (CT2) counting means for computing a number n-q able to allow, in the case, the correction of the error burst in said code word (r(X)).

10. A decoding device as claimed in claim 8 or 9, characterized in that it further comprises an (n-b) stages buffer register (BF) serially connected to said input means.


**Patentansprüche**

1. Verfahren zur Dekodierung eines verkürzten zyklischen Binärcodes, das imstande ist, einzelne Fehlerbursts b(x) mit vorgegebener Länge t oder kürzer zu korrigieren, besonders ein F(n-b,k-b) verkürzter Fire Code mit Generatorpolynom $g(x)=(x^{2t-1}+1) \cdot p(x)$, wobei p(x) ein Primpolynom über GF(2) ist mit der Periode ro, das der ro>(n-b) Kondition genügt, wobei:

das empfangene Codewort r(x) in einem Schiftregister als empfangener Vektor zwischengespeichert wird und die Syndrompolynomen s1(x) und s2(x) in (n-b) Zyklen berechnet werden;

das Polynom s1(x) eine $\Gamma$1 Anzahl von Malen in eine erste Richtung geschiftet wird bis alle Nullen in der (t-1) Stellung höherer Ordnung erscheinen, um den Burst b(x) mit der Länge t in der Stellung niedriger Ordnung einzufangen;

dieses Verfahren wird durch folgendes gekennzeichnet:

- Schiften des verbliebenen Polynoms S2(x) in eine Gegenrichtung zu der angegebenen ersten Richtung bis die Struktur der t Bits niedriger Ordnung mit der im besagten Burst b(x) mit der Länge t übereinstimmt, und Bestimmung einer Zahl $\Gamma$2 gleich (ro-h), wobei h die Anzahl der durchgeführten Schiftvorgänge ist;
- Berechnung von (n-q) durch die Relation:
- q = $\Gamma$1.A2.ro + $\Gamma$2.A1.(2t - 1)   mod(n)
  wobei A1 und A2 zwei positive Ganzzahlen sind, so dass:
  A1.(2t - 1) + A2.ro = 1;
- Durchführung der Korrektur durch Addieren Modulo 2 des Polynoms $(x^{n-q}) \cdot b(x)$ zum

empfangenen Vektor.

2. Verfahren entsprechend Anspruch 1, dadurch gekennzeichnet, dass (n-b)<ro/2.

3. Verfahren entsprechend den Ansprüchen 1 und 2, dadurch gekennzeichnet, dass ro und (2t-1) keinen gemeinsamen Teiler haben.

4. Verfahren entsprechend Anspruch 3, dadurch gekennzeichnet, dass, falls $\Gamma$2 kleiner als ro - (n-b) +1 ist, das Verfahren gestoppt wird, da der Fehlerburst grösser als t ist.

5. Verfahren entsprechend Anspruch 4, dadurch gekennzeichnet, wenn die aus Bits der niedrigsten Ordnung von s2(x) bestehende Struktur gleich der im zwischen gespeicherten Burst von der Länge t ist ohne die Notwendigkeit des Schiftens des Polynoms, dass dann $\Gamma$2 0 gleichgesetzt ist und (n-q) = 0.

6. Verfahren zur Dekodierung eines verkürzten zyklischen Binärcodes, das in der Lage ist, einzelne Fehlerbursts b(x) mit der vorgegebenen Länge t oder kürzer zu korrigieren, besonders einen F(n-b,k-b) verkürzten Fire Code mit einem Generatorpolynom $g(x)=(x^{2t-1}+1) \cdot p(x)$, wobei p(x) ein Primpolynom über GF(2) mit der Periode ro ist, in dem mittels zyklischer Schiftvorgänge die Zahl r2 gleich (ro-h) berechnet wird, wobei h durch eine Anzahl von Schiftvorgängen bestimmt wird, die notwendig sind, um den Fehlerburst b(x) in den weniger bedeutenden Stellungen des Syndroms s2(x) zu erhalten, und dieses Verfahren wird dadurch gekennzeichnet, dass (n-q) durch die Relation

n - q = $\Gamma$2 + 1 - ro

berechnet und die Korrektur durch Addition Modulo 2 des Polynoms $(x^{n-q}) \cdot b(x)$ zum empfangenen Vektor durchgeführt wird.

7. Verfahren entsprechend Anspruch 6, dadurch gekennzeichnet, dass ro der Relation

ro>(n - b)

genügt.

8. Vorrichtung zur Dekodierung eines verkürzten zyklischen Binärcodes, besonders eines F(n-b,k-b) verkürzten Codes mit einem Generatorpolynom mit der Formel

$g(x) = (x^{2t-1} + 1) \cdot p(x)$,

wobei p(x) ein Primpolynom über GF(2) mit der Periode ro ist, das der Kondition ro>(n-b) genügt, wobei besagte Vorrichtung imstande ist, einzelne Fehlerbursts mit einer vorgegebenen Länge t zu korrigieren, und dadurch gekennzeichnet, dass sie folgendes einschliesst:

Eingabeeinheiten für ein Codewort (r(X));

ein erstes in eine Richtung laufendes Schiftregister (SR1) mit (2t-1) Stufen, das durch Reihenschaltung mit den genannten Eingabeeinheiten verbunden ist;

ein zweites in eine Richtung laufendes Schiftregister (SR2) mit m Stufen, das durch Reihenschaltung mit den genannten Eingabeeinheiten verbunden ist;

eine Null-Test-Schaltung (TS) parallel geschaltet mit den (t-1) Stufen höherer Ordnung des genannten ersten Registers (SR1);

erste Recheneinheiten (CT1) Modul (2t-1), die geeignet sind, die Anzahl der Schiftvorgänge zu berechnen, die vom genannten ersten Register (SR1) ausgeführt werden;

gekennzeichnet dadurch, dass weiter folgendes eingeschlossen ist:

ein drittes in eine Richtung laufendes Schiftregister (MEL) mit m Stufen, die durch Parallelschaltung mit dem genannten zweiten Register (SR2) verbunden sind, und geeignet, Daten in eine Richtung zu schiften, die der des obengenannten ersten und zweiten Registers (SR1, SR2) entgegengesetzt ist;

eine Kontrollvorrichtung (MTC), parallel geschaltet zwischen den t Stufen niedrigster Ordnung des genannten in eine Richtung laufenden Schiftregisters (SR1) und dem genannten dritten Schiftregister (MEL), wobei der Ausgang der genannten Kontrollvorrichtung (MTC) mit den zweiten Rechenmeinheiten (CT2) Modulo ro verbunden ist, die geeignet sind, die Anzahl der vom zweiten genannten Register (SR2) durchgeführten Schiftvorgänge zu berechnen;

eine Rechenschaltung (COMP), die mit den Ausgängen der genanten ersten (CT1) und zweiten (CT2) Recheneinheiten für die Berechnung einer Zahl n-q verbunden ist, wobei letztere geeignet ist, die eventuelle Korrektur des Fehlerbursts im genannten Codewort (r(X zu ermöglichen.

9. Vorrichtung zur Dekodierung eines verkürzten zyklischen Binärcodes, besonders eines F(n-b,k-b) verkürzten Codes mit einem Generatorpolynom mit der Formel
$$g(x) = (x^{2t-1} + 1).p(x)$$
wobei p(x) ein Primpolynom über GF(2) mit der Periode ro ist, das der Kondition ro>(n-b) genügt, wobei die genannte Vorrichtung geeignet ist, einzelne Fehlerbursts mit einer vorgegebenen Länge t zu korrigieren und folgendes einschliesst:

Eingabeeinheiten für ein Codewort (r(X));

ein erstes in eine Richtung laufendes Schiftregister (SR1) mit (2t-1) Stufen, die in Reihenschaltung mit mit den genannten Eingabeeinheiten verbunden sind;

ein zweites Schiftregister (SRb) mit m Stufen, das durch Reihenschaltung mit den genannten Eingabeeinheiten verbunden ist;

eine Null-Test-Schaltung (TS), die parallel mit den Stufen höherer Ordnung des genannten ersten Registers (SR1) verbunden ist;

erste Recheneinheiten (CT1) Modulo (2t-1), die geeignet sind, die Anzahl der vom genannten ersten Register (SR1) ausgeführten Schiftvorgänge zu berechnen; dadurch gekennzeichnet, dass

das genannte zweite Schiftregister (SRb) ein in zwei Richtungen laufendes Schiftregister ist, und dass die genannte Vorrichtung weiter folgendes beinhaltet:

eine Kontrollvorrichtung (MTC), die zwischen den t Stufen niedrigster Ordnung des genannten ersten in eine Richtung laufenden Schiftsregister (SR1) und dem genannten zweiten in zwei Richtungen laufenden Schiftregister (SRb) parallelgeschaltet ist, wobei der Ausgang der genanntenu Kontrollvorrichtung (MTC) mit den zweiten Recheneinheiten (CT2) Modulo ro verbunden ist, welche geeignet sind, die Anzahl der durch das genannte zweite Register (SRb) ausgeführten Schiftvorgänge zu berechnen;

eine Rechenschaltung (COMP), die mit den Ausgängen der ersten (CT1) und zweiten (CT2) Recheneinheiten für die Berechnung einer Zahl n-q verbunden ist, die geeignet ist, die eventuelle Korrektion eines Fehlerbursts im genannten Codewort (r(X)) zu ermöglichen.

10. Eine Vorrichtung zur Dekodierung entsprechend den Ansprüchen 8 oder 9, gekennzeichet dadurch, dass sie weiter einen (n-b) Stufenpufferregister (BF) einschliesst, das mit den genannten Eingabeeinheiten reihengeschaltet ist.

## Revendications

1. Procédé de décodage d'un code binaire cyclique raccourci apte à corriger des bursts d'erreurs individuels b(x) de longueur déterminée t ou inférieure, en particulier un code Fire raccourci F(n-b,k-b) de polynôme générateur $g(x)=(x^{2t-1}+1).p(x)$, avec p(x) polynôme premier sur GF(2) avec période ro, satisfaisant à la condition ro>(n-b), où

le mot de code reçu r(x) est mémorisé dans un registre à décalage comme vecteur reçu, et les polynômes syndrome s1(x) et s2(x) sont calculés en (n-b) cycles;

le polynôme s1(x) est cycliquement décalé Γ1 fois dans une première direction, jusqu'à obtenir tous les zéros dans la position (t-1) d'ordre supérieur pour piéger le burst b(x) de longueur t dans les positions d'ordre inférieur;

le dit procédé est caractérisé par le fait de:

- décaler le polynôme restant s2(x) dans une direction opposée à la dite première s2(x) jusqu'à ce que la configuration des t bits d'ordre inférieur coïncident avec celle du dit burst b(x) de longueur t, et déterminer un nombre $\Gamma 2$ égal à (ro-h), où h est le nombre d'opérations de décalage effectuées;
- calculer (n-q) moyennant la relation

$$q = \Gamma 1.A2.ro + \Gamma 2.A1.(2t - 1) \quad mod(n)$$

où A1 et A2 sont deux nombres entiers positifs, ainsi:

$$A1.(2t - 1) + A2.ro = 1$$

- effectuer la correction en additionnant modulo 2 le polynôme $(x^{n-q}).b(x)$ au vecteur reçu.

2. Procédé comme sous 1, caractérisé en ce que (n-b)<ro/2.

3. Procédé comme sous 1 et 2, caractérisé en ce que ro et (2t-1) sont premiers l'un à l'autre.

4. Procédé comme sous 3, caractérisé en ce que si $\Gamma 2$ est inférieur à ro- (n-b) +1, le procédé s'arrête, parce que la longueur du burst d'erreurs est supérieure à t.

5. Procédé comme sous 4, caractérisé en ce que si la configuration consistant en bits d'ordre inférieur de s2(x) coïncide avec celle du burst piégé de longueur t sans nécessité de décaler le polynôme s2(x), alors $\Gamma 2$ est mis égal à zéro et (n-q)=0.

6. Procédé de décodage d'un code binaire cyclique raccourci, apte à corriger des bursts d'erreurs b(x) individuels de longueur déterminée t ou inférieure, en particulier un code Fire raccourci F(n-b,k-b) ayant un polynôme générateur $g(x)=(x^{2t-1}+1).p(x)$, p(x) étant un polynôme premier sur GF(2) et de période ro, où le nombre $\Gamma 2$ égal à (ro-h) est calculé par des opérations de décalage cycliques, avec h déterminé par le nombre d'opérations de décalage nécessaire pour obtenir le burst d'erreurs b(x) dans les t positions moins significatives du syndrome s2(x), dit procédé étant caractérisé par le fait de calculer (n-q) moyennant la relation:

$$n - q = \Gamma 2 + 1 - ro$$

et d'effectuer la correction en additionnant modulo 2 le polynôme $(x^{n-q}).b(x)$ au vecteur reçu.

7. Procédé comme sous 6, caractérisé en ce que ro satisfait à la relation:

$$ro > (n - b).$$

8. Dispositif de décodage d'un code binaire cyclique raccourci, en particulier un code Fire raccourci F(n-b), k-b) ayant un polynôme générateur $g(x)=(x^{2t-1}+1).p(x)$, où p(x) est un polynôme premier su GF(2) et de période ro, satisfaisant à la condition ro>(n-b), et ce dispositif étant apte à corriger des bursts d'erreurs individuels de longueur déterminée t et de comporter:

des moyens d'entrée pour un mot de code (r(X));

un premier registre à décalage unidirectionnel (SR1) avec (2t-1) étages branchés en série aux dits moyens d'entrée;

un deuxième registre à décalage unidirectionnel (SR2) avec m étages branchés en série aux dits moyens d'entrée;

un circuit test zéro (TS) branché en parallèle aux (t-1) étages d'ordre supérieur du dit premier registre (SR1);

des premiers moyens de comptage (CT1) modulo (2t-1), apte à compter le numéro d'opérations de décalage effectuées par le dit premier registre (SR1);

caractérisés en ce qu'il comporte en plus:

un troisième registre à décalage unidirectionnel (MEL) avec m étages, relié en parallèle au dit deuxième registre (SR2) et capable de décaler des données dans une direction opposée à celle du premier et deuxième registre (SR1, SR2) mentionnés ci-dessus;

un dispositif comparateur (MTC) branché en parallèle entre les t étages d'ordre inférieur du dit premier registre à décalage unidirectionnel (SR1) et le dit troisième registre à décalage (MEL), la sortie du dit comparateur (MTC) étant branchée aux deuxièmes moyens de comptage modulo ro (CT2) apte à compter le nombre d'opérations de décalage effectuées par le dit deuxième registre (SR2);

un circuit de computation (COMP) branché aux sorties des dits premiers (CT1) et deuxièmes (CT2) moyens de comptage pour calculer un nombre n-q, apte à consentir la correction éventuelle du burst d'erreurs dans le dit mot de code (r(X)).

9. Dispositif de décodage d'un codes binaires cycliques raccourcis, en particulier un code raccourci F(n-b,k-b) ayant un polynôme générateur sous la forme de

$$g(x) = (x^{2t-1} + 1).p(x)$$

où p(x) étant un polynôme premier sur GF(2) avec période ro, satisfaisant à la condition ro>(n-b), le dit dispositif de décodage étant apte à corriger des bursts d'erreurs individuels d'une longueur déterminée t et consistant en:

des moyes d'entrée pour un mot de code (r(X));

un premier registre à décalage unidirectionnel (SR1) avec (2t-1) étages, branché en série aux dits moyens d'entrée;

un deuxième registre à décalage (SRb) avec m stades branché en série aux dits moyens d'entrée;

un circuit test zéro (TS) branché en parallèle aux (t-1) étages d'ordre supérieur du dit premier registre (SR1);

des premiers moyens de comptage (CT1) modulo (2t-1), apte à calculer le nombre d'opérations de décalage effectuées par le premier registre (SR1);

caractérisé en ce que

le dit deuxième registre à décalage (SRb) est un registre à décalage bidirectionnel et que le dit dispositif consiste en plus en:

un dispositif comparateur (MTC) branché en parallèle entre les t étages d'ordre inférieur du dit premier registre à décalage unidirectionnel (SR1) et du dit deuxième registre à décalage (SRb), la sortie du dit comparateur (MTC) étant branchée aux deuxième moyens de comptage modulo ro (CT2), aptes à calculer le nombre d'opérations de décalage effectuées par le dit deuxième registre (SRb);

un circuit de computation (COMP) branché aux sorties des dits premiers (CT1) et deuxièmes (CT2) moyens de comptage pour calculer un nombre n-q, apte à consentir la correction éventuelle des bursts d'erreurs dans le dit mot de code r(X)).

10. Un dispositif de décodage comme sous 8 ou 9, caractérisé en ce qu'il consiste en plus en un registre buffer (BF) de (n-b) étages branché aux dits moyens d'entrée.

# _Fig.1_

## _Fig.2_

## _Fig.3_